# EUROPEAN PATENT APPLICATION

(11) **EP 2 455 853 A2**
(43) Date of publication of application: **23.05.2012**
(21) Application number: 10799967.4
(22) Date of filing: 01.06.2010
(51) Int. Cl.: G06F 9/06, G06F 9/00

(54) **DATA COMPRESSION METHOD**

(30) Priority: 17.07.2009 KR 20090065526
(71) Applicant: Estsoft Corp., Seoul 151-836 (KR)
(72) Inventor: OH, Yun Sik, Seoul 152-070 (KR)
(74) Representative: Schumacher & Willsau
(86) International application number: PCT/KR2010/003489
(87) International publication number: WO 2011/007956

(57) **Abstract**

Disclosed herein is a data compression method for improving a compression rate when compressing computer data by employing both a method of generating a character string dictionary and storing indexes and a method of storing compression codes corresponding to character strings. Accordingly, a compression rate and a decompression speed increase.

## Description

### BACKGROUND OF THE INVENTION

### Field of the Invention

The present invention relates to a data compression method, and more particularly, to a data compression method for improving a compression rate when compressing computer data by employing both a method of generating a character string dictionary and storing indexes and a method of storing compression codes corresponding to character strings.

### Background of the Related Art

Generally, data compression converts the original data in a predetermined format into data in another format including data bits less than the data bits of the original data. When the original data is needed, the compressed data is decompressed to restore the data in the original format.

Data compression can be classified into lossy compression and lossless compression. As represented by the terminologies, data maintains its original form while compressed and decompressed in case of the lossless compression. On the contrary, decompressed data may be not identical to the original data in case of the lossy compression. Lossless data compression algorithms are classified into dictionary coding and statistical coding types.

Widely used dictionary coding algorithms include Lempel-Ziv algorithms and their variations. Particularly, LZ77 algorithm designates a compression method disclosed by Ziv et al in 1977 and LZ78 denotes a compression method disclosed by Ziv et al in 1978.

LZ77 is based on the principle that repeated sequences of characters are replaced with reference to previous generation of sequences according to a pointer. LZ78 parses input data character streams into coded values based on an adaptively growing reference source such as a look-up table or a dictionary for string matching.

Conventional compression algorithms compress data by using only a single method such as string encoding or dictionary encoding. When a single method is used for compression, a compression rate and a compression speed may increase or decrease according to data property. If two methods are used to compress and decompress data and an encoding result obtained from a method producing better efficiency is stored during compression, the best speed and efficiency can be secured all the time.

### SUMMARY OF THE INVENTION

Accordingly, the present invention has been made in view of the above-mentioned problems occurring in the prior art, and it is a primary object of the present invention to provide a data compression method which stores repeatedly appearing character strings among character strings included in original data in a dictionary table to store only indexes, compresses character strings that do not repeatedly appear or appear less frequently using a string encoding method and store the encoded strings to achieve efficient compression.

It is another object of the present invention to provide a data compression method which calculates the probability of appearance of a character after a specific previous character when encoding character strings and stores the probability together with the encoded character strings to improve a search or decompression speed.

It is still another object of the present invention to provide a data compression method that stores some of characters, which appear most recently in a character string appearing during an encoding operation, in a table to improve a compression rate.

To accomplish the above object of the present invention, according to the present invention, there is provided a data compression method including a first step of extracting a repeated character string appearing more than twice among character strings included in original data; a second step of calculating a Hash value of the extracted repeated character string, storing the Hash value in a dictionary table, encoding the repeated character string and storing the encoded character string in compressed data; a third step of encoding character strings other than the repeated character string included in the original data according to LZ77 (Lempel-Ziv 77) algorithm and storing the encoded character strings in the compressed data; and a fourth step of calculating the probability of appearance of a specific character after a previous character in the encoding operation of the third step and storing the probability in the compressed data.

The fourth step may include the steps of calculating the probability of appearance of a specific character after a single specific character and storing the probability; and grouping characters, which have the same remainder when ASCII values corresponding to the characters are divided by 8, to form a character group, calculating the probability of appearance of a specific character after the character group and storing the probability.

The fourth step may store only the probability higher than the other calculated in the steps.

The data compression method may further include a fifth step of generating a list of several character strings most recently appearing in the encoding operation of the second or third step and storing the list and indexes corresponding to the character strings in the compressed data.

According to the present invention, a compression rate and a decompression speed increase.

### BRIEF DESCRIPTION OF THE DRAWINGS

The above and other objects, features and advantages of the present invention will be apparent from the following detailed description of the preferred embodiments of the invention in conjunction with the accompanying drawings, in which:

FIG.1 illustrates a compression method according to an embodiment of the present invention;

FIG. 2 illustrates a method of searching for a character string stored in a dictionary table by using a Hash value;

FIG. 3 illustrates a method of calculating the probability of appearance of a specific character after a previous character;

FIG. 4 illustrates a method of calculating the probability of appearance of a specific character after a specific character group.

### DETAILED DESCRIPTION OF THE PREFERRED EMBODIMENT

A data compression method (refer to as 'compression method' hereinafter) according to an embodiment of the present invention will now be explained with reference to the attached drawings.

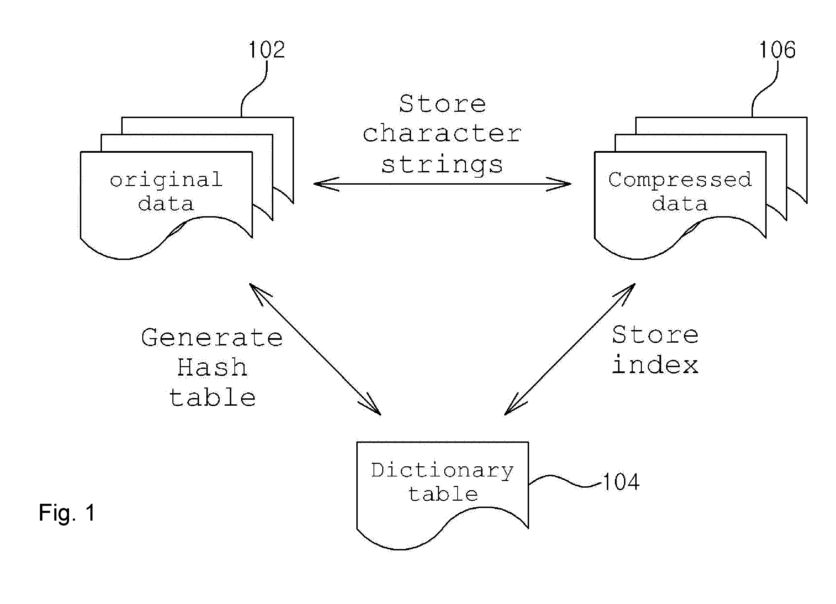

FIG.1 illustrates a compression method according to an embodiment of the present invention.

Types of data that can be compressed by the compression method of the present invention are not limited to documents or texts and can include images, music and other multimedia data.

Original data 102 to be compressed is converted into compressed data 106 through a character string storage method and a dictionary storage method.

A Hash table is generated using character strings appearing during encoding in several length units. Repeated character strings are stored in a dictionary table 104.

Data is compressed block by block. A block size does not concern a compression speed but affects a compression rate. In general, the compression rate increases but memory usage also increases as the block size increases. The block size corresponding to a compression unit can be freely set by a user in consideration of the compression rate and a file size.

Memory usages in compression and decompression are represented by the following equations.

Memory usage (for compression)=Block size x 2 + Hash table size

Memory usage (for decompression)=Block size x 2

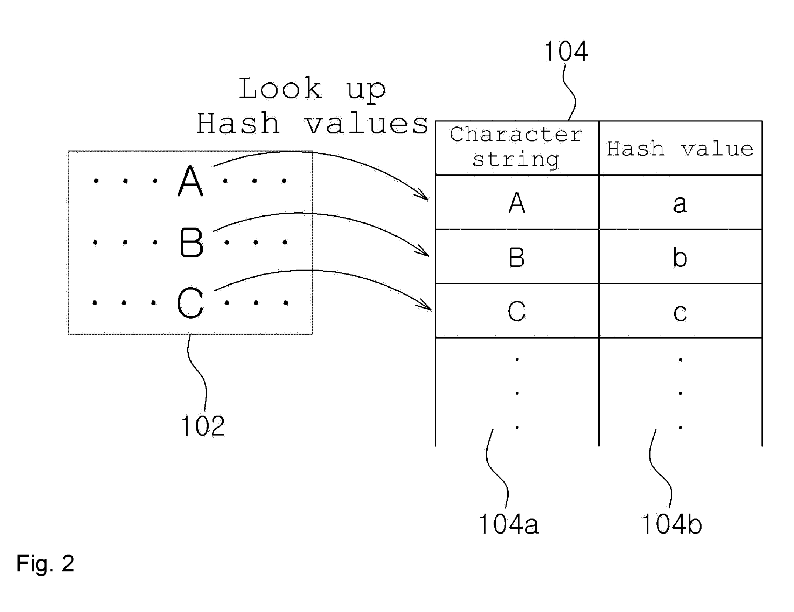

FIG. 2 illustrates a method of searching for a character string stored in the dictionary table 104 by using a Hash value and shows a structure of a Hash table 104b stored in the dictionary table 104.

A method of generating the Hash table 104b will now be explained.

Hash values of character strings 104a having lengths corresponding to 2^{N} (2, 4, 8, 16, 32, ...) in the original data 102 are calculated and stored in the Hash table 104b. Here, the calculated Hash values may be stored with the strings 104a corresponding to the Hash values. The string length and Hash value size can be designated when the data is compressed.

A longer character string can be matched and thus the compression rate can increase as the string length increases. In addition, Hash collision can be prevented and thus the compression rate can increase as the Hash value size increases. However, memory usage increases as the string length and the Hash value size increase. Particularly, a long string length increases the quantity of computations to decrease the compression speed.

The Hash values are stored in the form of a distance between strings and a string length, similarly to LZ77. The compression rate increases if indexes of the Hash table 104b are stored. In this case, however, the Hash table 104b must be generated even when data is decoded, and thus a decoding speed is decreased to as low as the compression speed. Accordingly, the present invention stores the Hash values according to (distance, length) method used for general compression algorithms.

It is determined whether the same Hash value as a Hash value generated when the original data 102 is encoded exists in the Hash table 104b. A character string stored in the Hash table 104b may have a maximum length of 128.

When the Hash table 104b in the dictionary table 104 is searched for the same Hash value and the same Hash value exists in the Hash table 104b, it can be determined that the same character string exits, and the index of the character string having the same Hash value is stored in the compressed data 106.

Although the compression rate increases as the number of character strings stored in the dictionary table 104 increases, the compression speed may decrease since it is required to search a large number of character strings or Hash values. Furthermore, if the number of dictionaries is increased, types of indexes required to be stored in the dictionaries are increased and thus the compression rate does not increase any more.

When characters are stored in the compressed data 106, the probability of appearance of a specific character after a specific previous character is calculated and stored with the character. In this case, the number of bits of the index of a character string can be reduced to improve compression efficiency.

There are two methods of calculating the probability of appearance of a character. One of the two methods calculates the probability of appearance of a specific character after a specific single character.

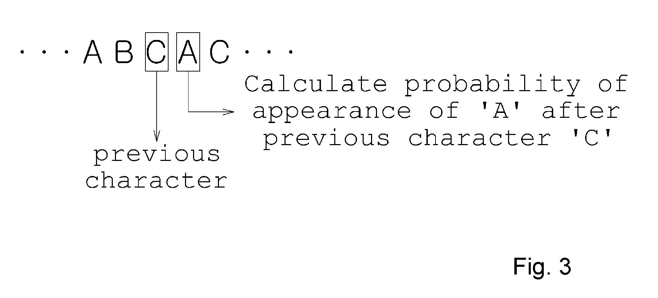

FIG. 3 illustrates a method of calculating the probability of appearance of a specific character after a previous character. FIG. 3 shows that the previous character is a specific single character.

For example, the probability of appearance of a specific character 'A' after a specific character 'C' in an encoding operation is calculated and stored with the character in the compressed data 106. The probability of appearance of the specific character is calculated by accumulating instances generated during previous encoding operations. If the probability of appearance of the specific character after the previous character is calculated in advance and stored, a dictionary or string search range can be limited in a decompression process, and thus decoding time decreases.

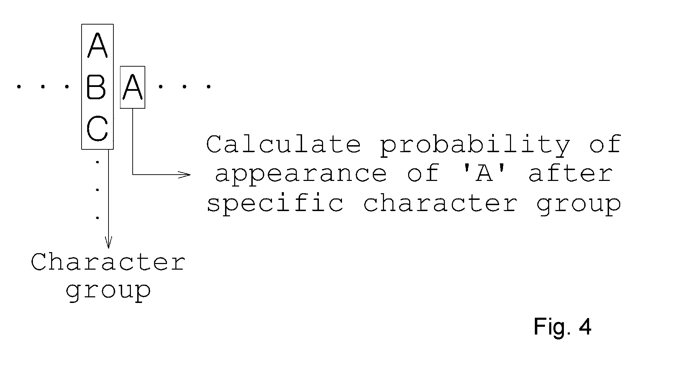

FIG. 4 illustrates a method of calculating the probability of appearance of a specific character after a specific character group.

A character group is obtained by classifying character strings according to a specific rule in order to calculate the probability of appearance of a specific character after a character string included in the original data 102. ASCII values respectively representing character strings are obtained and character strings, which have the same remainder when the ASCII values corresponding to the character strings are divided by a specific numeral, are grouped to form a specific character group.

If character strings, which have the same remainder when the ASCII values corresponding thereto are divided by 8, form a group, eight character groups will be generated. Although the present invention is explained on the assumption that eight character groups are generated, more than eight character groups can be generated and used.

Referring to Fig. 4, the probability of appearance of a specific character 'A' after characters A, B and C, which have the same remainder when ASCII values corresponding thereto are divided by 8, is calculated. If ASCII values corresponding to A, B and C are 65, 73 and 81, for example, the remainder obtained when the three ASCII values are divided by 8 becomes 1. Accordingly, A, B and C can be classified as a character group having the remainder of 1. Probabilities calculated for respective character groups are stored with the character groups in the compressed data 106.

The method having a higher compression rate is selected from the two methods to perform final compression. That is, the method that achieves a higher compression rate is selected from the method of calculating the probability of appearance of a specific character after a previous character and the method of calculating the probability of appearance of a specific character after a specific character group. The method having higher probability is selected and used to decompress the compressed data 106.

However, information on the selected method may not be stored when the compressed data 106 is stored. If the information on the selected method is stored with the compressed data 106, the compression rate decreases although the decoding speed increases.

When the information on the selected compression method is not stored, decompression operations with respect to the two methods are simultaneously performed during the decoding process, the method having a higher compression rate is selected from the two methods and the original data 102 is restored by using the selected method.

The present invention separately stores and manages information on most recently appearing several values when compression or decompression is performed. There is a great possibility that the same character string repeatedly appears in a near position during data encoding and decoding operations. In this case, it is inefficient to newly search or encode characters, and thus histories of a predetermined number of character strings are stored to achieve rapid search.

A list of several character strings that appear most recently during an encoding operation is created and indexes of the character strings included in the list are generated. The list and the indexes are stored together in the compressed data 106.

Preferably, ten to twenty character strings are stored. The number of character strings stored in past history is varied by those skilled in the art.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

## Claims

1. A data compression method comprising:
a first step of extracting a repeated character string appearing more than twice among character strings included in original data;
a second step of calculating a Hash value of the extracted repeated character string, storing the Hash value in a dictionary table, encoding the repeated character string and storing the encoded character string in compressed data;
a third step of encoding character strings other than the repeated character string included in the original data according to LZ77 (Lempel-Ziv 77) algorithm and storing the encoded character strings in the compressed data; and
a fourth step of calculating the probability of appearance of a specific character after a previous character in the encoding operation of the third step and storing the probability in the compressed data.

2. The data compression method of claim 1, wherein the fourth step comprises the steps of:
calculating the probability of appearance of a specific character after a single specific character and storing the probability; and
grouping characters, which have the same remainder when ASCII values corresponding to the characters are divided by 8, to form a character group, calculating the probability of appearance of a specific character after the character group and storing the probability.

3. The data compression method of claim 2, wherein the fourth step stores only the probability higher than the other calculated in the steps.

4. The data compression method of claim 1, further comprising a fifth step of generating a list of several character strings most recently appearing in the encoding operation of the second or third step and storing the list and indexes corresponding to the character strings in the compressed data.
